# EUROPEAN PATENT APPLICATION

(11) **EP 2 511 954 A1**
(43) Date of publication of application: **17.10.2012**
(21) Application number: 12163107.1
(22) Date of filing: 04.04.2012
(51) Int. Cl.: H01L 25/18, H03K 17/567

(54) **Stacked composite device including a group III-V transistor and a group IV diode**

(30) Priority: 11.04.2011 US 201161473907 P; 29.03.2012 US 201213434524
(71) Applicant: International Rectifier Corporation, El Segundo, CA 90245 (US)
(72) Inventor: McDonald, Tim, Redondo Beach, CA 90277 (US); Briere, Michael A., Scottsdale, AZ 85266 (US)
(74) Representative: Dr. Weitzel & Partner

(57) **Abstract**

In one implementation, a stacked composite device comprises a group IV diode and a group III-V transistor stacked over the group IV diode. A cathode of the group IV diode is in contact with a source of the group III-V transistor, an anode of the group IV diode is coupled to a gate of the group III-V transistor to provide a composite anode on a bottom side of the stacked composite device, and a drain of the group III-V transistor provides a composite cathode on a top side of the stacked composite device.

## Description

### BACKGROUND

The present application claims the benefit of and priority to a pending provisional application entitled "Group III-Nitride and Group IV Composite Device," Serial No. 61/473,907 filed on April 11, 2011. The disclosure in this pending provisional application is hereby incorporated fully by reference into the present application.

### I. DEFINITIONS

As used herein, the phrase "group III-V" refers to a compound semiconductor including at least one group III element and at least one group V element. By way of example, a group III-V semiconductor may take the form of a III-Nitride semiconductor. "III-Nitride" or "III-N" refers to a compound semiconductor that includes nitrogen and at least one group III element including aluminum (Al), gallium (Ga), indium (In), and boron (B), and including but not limited to any of its alloys, such as aluminum gallium nitride (AlₓGa₍₁₋ₓ₎N), indium gallium nitride (In_{y}Ga_{(1-y)}N), aluminum indium gallium nitride (AlₓIn_{y}Ga_{(1-x-y)}N), gallium arsenide phosphide nitride (GaAsₐP_{b}N_{(1-a-b)}), aluminum indium gallium arsenide phosphide nitride (AlₓIn_{y}Ga_{(1-x-y)}ASₐP_{b}N_{(1-a-b)}), for example. III-Nitride also refers generally to any polarity including but not limited to Ga-polar, N-polar, semi-polar or non-polar crystal orientations. A III-Nitride material may also include either the Wurtzitic, Zincblende or mixed polytypes, and may include single-crystal, monocrystalline, polycrystalline, or amorphous structures.

Also as used herein, the phrase "group IV" refers to a semiconductor that includes at least one group four element including silicon (Si), germanium (Ge) and carbon (C), and also includes compound semiconductors such as silicon germanium (SiGe) and silicon carbide (SiC), for example. Group IV also refers to semiconductor materials which include more than one layer of group IV elements, or doping of group IV elements to produce strained group IV material, and may also include group IV based composite substrates such as silicon on insulstor (SOI), separation by implantation of oxygen (SIMOX) process substrates, and silicon on sapphire (SOS), for example.

### II. BACKGROUND ART

In high power and high performance circuit applications, III-Nitride transistors, such as gallium nitride (GaN) field-effect transistors (FETs) and high mobility electron transistors (HEMTs), are often desirable for their high efficiency and high-voltage operation. Moreover, it is often desirable to combine such III-Nitride transistors with other semiconductor devices, such as low-voltage (LV) silicon diodes, to create high performance composite switching devices.

In power management applications where normally OFF characteristics of power devices are desirable, a depletion mode (normally ON) III-Nitride transistor can be coupled to an LV group IV diode, for example a silicon diode, to produce an enhancement mode (normally OFF) composite power device. However, conventional packaging techniques for combining III-Nitride transistors with silicon devices often counterweigh the benefits provided by III-Nitride devices. For instance, conventional package designs may place discrete components side-by-side on a common support surface implemented using a ceramic based substrate such as a direct bonded copper (DBC) substrate, or a ceramic substrate on a lead-frame. Such side-by-side configuration can undesirably increase the parasitic inductance and resistance in the current paths of the composite power device, and would also increase the thermal dissipation requirements of the package. Moreover, the side-by-side placement of devices on a common substrate can undesirably increase package form factor, as well as manufacturing costs.

### SUMMARY

The present disclosure is directed to a stacked composite device including a group **III-V** transistor and a group IV diode, substantially as shown in and/or described in connection with at least one of the figures, and as set forth more completely in the claims.

### BRIEF DESCRIPTION OF THE DRAWINGS

Figure 1 presents a diagram representative of one exemplary implementation of a composite device.
Figure 2A presents a perspective view showing a front side of an exemplary group III-V transistor suitable for use in a stacked composite device, according to one implementation.
Figure 2B presents a perspective view showing a back side of the exemplary group III-V transistor shown in Figure 2A.
Figure 3A presents a perspective view showing a top side of an exemplary group IV diode suitable for use in a stacked composite device, according to one implementation.
Figure 3B presents a perspective view showing a bottom side of the exemplary group IV diode shown in Figure 3A.
Figure 4 presents a perspective view showing a top side of an exemplary stacked composite device implemented using the transistor shown by Figures 2A and 2B, and the diode shown by Figures 3A and 3B.
Figure 5A presents a perspective view showing a front side of an exemplary group III-V transistor suitable for use in a stacked composite device, according to another implementation.
Figure 5B presents a perspective view showing a back side of the exemplary group III-V transistor shown in Figure 5A.
Figure 6 presents a perspective view showing a top side of an exemplary group IV diode suitable for use in a stacked composite device in combination with the group III-V transistor shown in Figure 5A and 5B.
Figure 7 presents a perspective view showing a top side of an exemplary stacked composite device implemented using the transistors shown by Figures 5A and 5B, and the diode shown by Figure 6.

### DETAILED DESCRIPTION

The following description contains specific information pertaining to implementations in the present disclosure. One skilled in the art will recognize that the present disclosure may be implemented in a manner different from that specifically discussed herein. The drawings in the present application and their accompanying detailed description are directed to merely exemplary implementations. Unless noted otherwise, like or corresponding elements among the figures may be indicated by like or corresponding reference numerals. Moreover, the drawings and illustrations in the present application are generally not to scale, and are not intended to correspond to actual relative dimensions.

111-Nitride materials include, for example, gallium nitride (GaN) and its alloys such as aluminum gallium nitride (AlGaN), indium gallium nitride (InGaN), and aluminum indium gallium nitride (AlInGaN). These materials are semiconductor compounds that have a relatively wide, direct bandgap and strong piezoelectric polarizations, and can enable high breakdown fields, high saturation velocities, and the creation of two-dimensional electron gases (2DEGs). As a result, III-Nitride materials such as GaN are used in many microelectronic applications as depletion mode (e.g., normally ON) and enhancement mode (e.g., normally OFF) power field-effect transistors (FETs) and high electron mobility transistors (HEMTs), for example.

In power management applications where normally OFF characteristics of power devices are required, a depletion mode III-Nitride or other group III-V device can be coupled with a low-voltage (LV) group IV semiconductor device, such as an LV silicon diode for example, with voltage rating being lower than approximately 50V, to produce an enhancement mode composite power device. However, the utility and reliability of such a composite device can be compromised by conventional packaging techniques for combining III-Nitride transistors with silicon or other group IV devices, which can often negate the benefits provided by III-Nitride devices. For example, and as noted above, conventional package designs may place discrete components side-by-side on a common support surface implemented using a ceramic based substrate such as a direct bonded copper (DBC) substrate, or a ceramic substrate on a lead-frame. Such side-by-side configuration can undesirably increase the parasitic inductance and resistance in the current paths of the composite power device, and would also increase the thermal dissipation requirements of the package. Moreover, the side-by-side placement of devices on a common substrate can undesirably increase package form factor, as well as manufacturing costs. As a result, a compact and cost-effective packaging solution for integrating III-Nitride or other group III-V transistors with group IV diodes is needed.

One approach to providing the needed packaging solution is implemented by the vertical stacking of the silicon or other group IV active die on top of the III-Nitride or other group III-V active die, as disclosed in U.S. Patent Application Number 13/053,646, entitled "III-Nitride Transistor Stacked with Diode in a Package," filed on March 22, 2011; as well as in U.S. Patent Application Number 13/053,556, entitled: "III-Nitride Transistor Stacked with FET in a Package," also filed on March 22, 2011, both of which are hereby incorporated by reference in their entirety.

The present application is directed to a stacked composite device wherein the group III-V active die is stacked on top of a silicon or group IV active die having a diode formed therein. The present approach is motivated in part by the larger die size typically required for the bottom die. That is to say, by implementing the bottom (larger) active die of the composite device using a less expensive group IV material such as silicon, and stacking a smaller active die formed of a costlier group III-V material such as GaN over the smaller group IV active die, the present application discloses a compact, cost effective packaging solution advantageously providing the performance advantages enabled by group III-V transistors.

According to one implementation, the stacked composite device may include a III-Nitride power transistor in combination with an LV group IV diode. The combination of the 111-Nitride power transistor, which may be a normally ON device, for example, with the LV group IV diode can be implemented to produce a normally OFF composite power device. Moreover, the composite device configurations disclosed by the present application are designed to substantially reduce parasitic inductance and resistance, and enhance thermal dissipation by a composite device package when compared to conventional integrated packaging solutions.

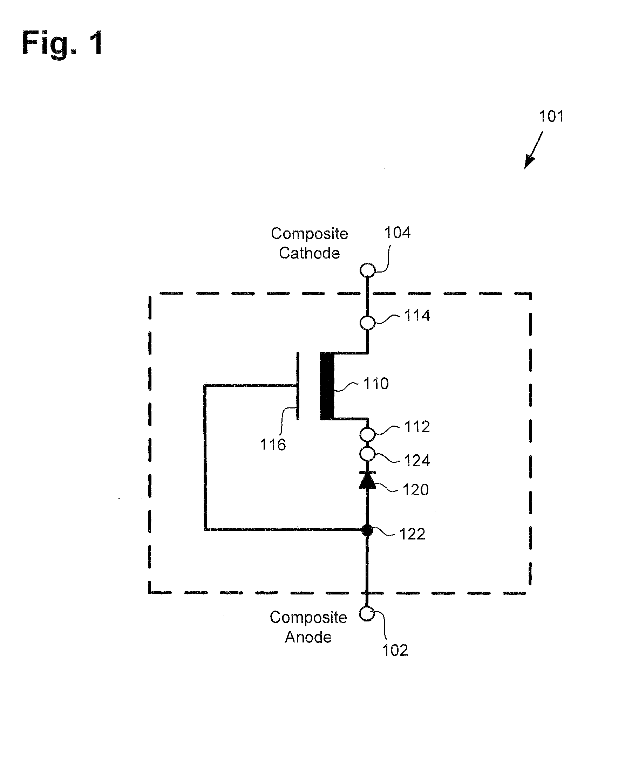

Referring to Figure 1, Figure 1 shows one exemplary implementation of a composite device. As shown in Figure 1, composite device 101 includes group III-V transistor 110 coupled with group IV diode 120. Also shown in Figure 1 are composite anode 102 and composite cathode 104 of composite device 101, as well as source 112, drain 114, and gate 116 of group III-V transistor 110, and anode 122 and cathode 124 of group IV diode 120.

Group III-V transistor 110 may be a III-Nitride power transistor and may be implemented as an insulated-gate FET (IGFET), or as a heterostructure FET (HFET), for example. In one implementation, group III-V transistor 110 may take the form of a metal-insulator-semiconductor FET (MISFET), such as a metal-oxide-semiconductor FET (MOSFET). Alternatively, when implemented as an HFET, group III-V transistor 110 may be a HEMT configured to produce a 2DEG. According to one implementation, for example, group III-V transistor 110 may be a high-voltage (HV) device configured to sustain a drain voltage of approximately 600V and having a gate rating of approximately 40V. It is noted that in some implementations, composite device 101 1 may utilize an insulated gate bipolar transistor (IGBT) as a power transistor in place of a group III-V FET or HEMT. It is further noted that composite device 101 may utilize a group III-V FET or HEMT other than a III-N FET or HEMT, such as a III-As, III-P or III-AsₐP_{b}N_{(1-a-b)} FET or HEMT, for example, as group III-V transistor 110.

According to the implementation shown by Figure 1, group IV diode 120 may be an LV group IV diode, such as a silicon diode having a breakdown voltage of less than approximately 50V, for example. However, in other implementations, group IV diode 120 may include any suitable group IV material. As shown in Figure 1, group III-V transistor 110 is coupled with group IV diode 120 to produce composite device 101. That is to say, cathode 124 of group IV diode 120 is coupled to source 112 of group III-V transistor 110, anode 122 of group IV diode 120 provides composite anode 102 for composite device 101, drain 114 of group III-V transistor 110 provides composite cathode 104 for composite device 101, and gate 116 of group III-V transistor 110 is coupled to anode 122 of group IV diode 120.

The combination of group III-V transistor 110 and group IV diode 120 produces composite device 101, which according to the implementation shown in Figure 1 results in a composite two terminal device functioning in effect as a diode having composite anode 102 provided by group IV diode 120, and composite cathode 104 provided by group III-V transistor 110. Moreover, and as will be described in greater detail below, composite device 101 may be implemented as an HV composite device configured to have reduced parasitic inductance and resistance, and enhanced thermal dissipation.

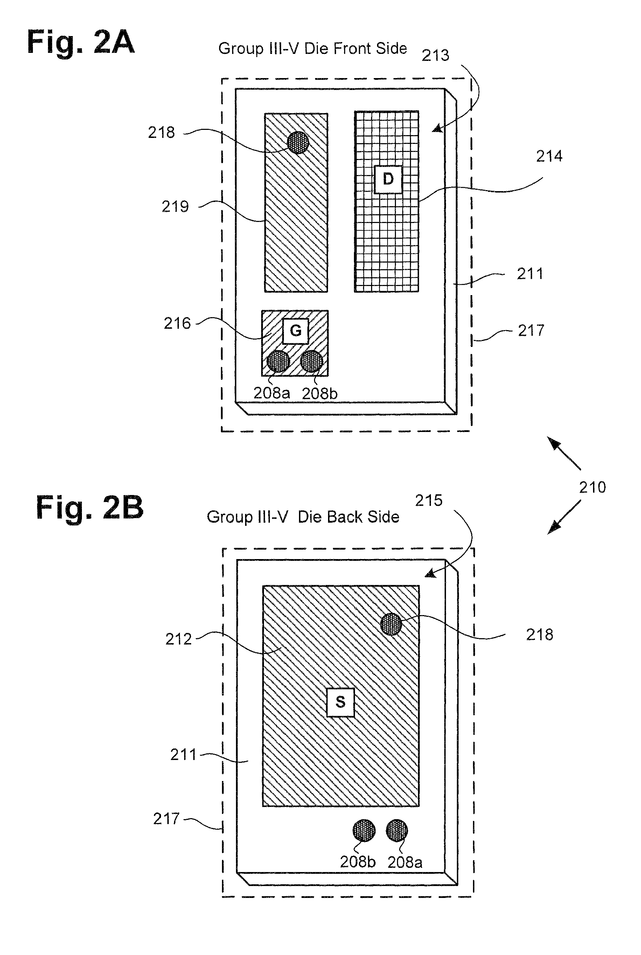

Continuing to Figures 2A and 2B, Figure 2A presents a perspective view showing front side 213 of exemplary group III-V transistor 210 suitable for use in a stacked composite device, according to one implementation, while Figure 2B presents a perspective view showing back side 215 of group III-V transistor 210. As shown by Figure 2A, group III-V transistor 210 includes active die 211 having lateral area 217 and including drain electrode 214, gate electrode 216, and source pad 219 formed on front side 213 of active die 211. Active die 211 may be formed of a III-Nitride material, for example, and may be implemented as a HEMT power device. As further shown by Figure 2B, source electrode 212 is formed on back side 215 of active die 211. Also shown in Figures 2A and 2B are respective upper and lower termini of through-substrate vias 208a, 208b, 218, such as through-silicon vias (TSVs) for example. Through-substrate vias 208a and 208b enable electrical coupling to gate electrode 216 on front side 213 of group III-V transistor 210 from back side 215 of active die 211, while through-substrate via 218 electrically couples source pad 219 on front side 213 to source electrode 212 on back side 215.

It is noted that although the front side terminus of through-substrate via 218 is visually depicted as "seen through" source pad 219 in the interests of conceptual clarity, in practice the front side terminus of through-substrate via 218 would be obscured by the presence of source pad 219 and thus would not be visible from the perspective view shown by Figure 2A. Similarly, although the front side termini of through-substrate vias 208a and 208b are depicted as "seen through" gate electrode 216, in practice those front side termini would be obscured by the presence of gate electrode 216 and thus would also not be visible from the perspective of Figure 2A. It is further noted that the back side terminus of through-substrate via 218 visually depicted as "seen through" source electrode 212 on back side 215 of active die 211 would be obscured by the presence of source electrode 212 and thus would not be visible from the perspective of Figure 2B. Group III-V transistor 210 having source pad 219 in contact with upper terminus of through-substrate via 218, source electrode 212, drain electrode 214, and gate electrode 216 in contact with upper termini of through-substrate vias 208a and 208b corresponds to group III-V transistor 110 having source 112, drain 114, and gate 116, in Figure 1, and may share any of the characteristics previously attributed to that corresponding device above.

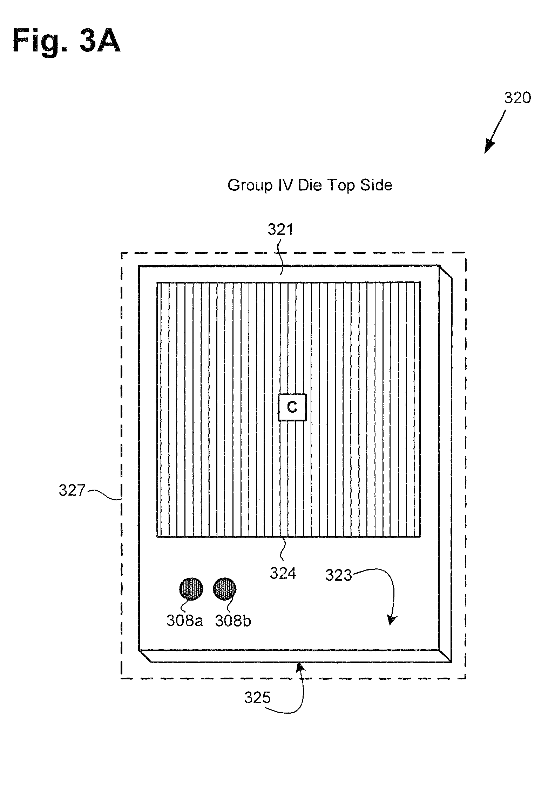

Moving to Figure 3A, Figure 3A presents a perspective view showing top side 323 of exemplary group IV diode 320 suitable for use in a stacked composite device, according to one implementation. As shown by Figure 3A, group IV diode 320 includes active die 321, which may be formed of any suitable group IV semiconductor, and includes cathode 324 and top side termini of through-substrate vias 308a and 308b, which may also be through-silicon vias (TSVs), for example, enabling electrical coupling to an anode on bottom side 325 of group IV diode 320 from top side 323 of active die 321 (anode not visible from the perspective of Figure 3A). In addition, Figure 3A shows lateral area 327 of active die 321. It is noted that group IV diode 320 is implemented as a vertical diode according to the present example. It is further noted that lateral area 327 of active die 321 is greater than lateral area 217 of active die 211, in Figures 2A and 2B.

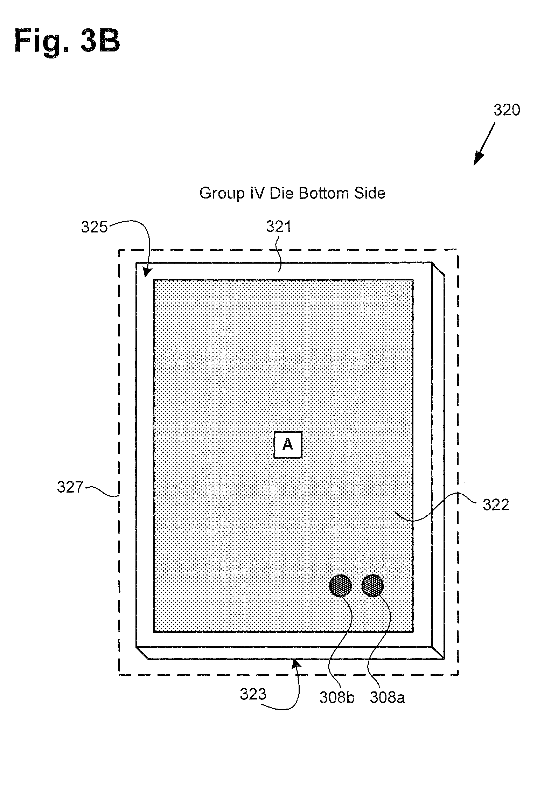

Continuing to Figure 3B, Figure 3B presents a perspective view showing bottom side 325 of exemplary group IV diode 320, consistent with the implementation shown by Figure 3A. As shown by Figure 3B, anode 322 of group IV diode 320 is formed on bottom side 325 active die 321. Also shown in Figure 3B are bottom side termini of through-substrate vias 308a and 308b, corresponding respectively to the top side termini show in Figure 3A. It is noted that although the bottom side termini of through-substrate vias 308a and 308b are visually depicted as "seen through" anode 322 in the interests of conceptual clarity, in practice the bottom side termini of through-substrate vias 308a and 308b would be obscured by the presence of anode 322 and thus would not be visible from the perspective view shown by Figure 3B.

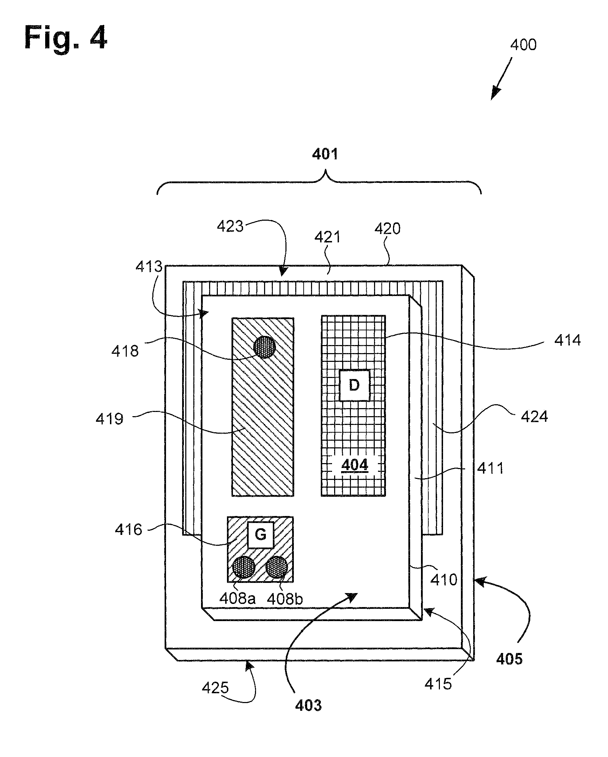

Referring now to Figure 4, Figure 4 presents a perspective view showing a top side of a packaging solution including an exemplary stacked composite device, according to one implementation. As shown in Figure 4, composite device package 400 includes stacked composite device 401 formed from group III-V transistor 410 stacked over group IV diode 420. Stacked composite device 401 corresponds to composite device 101, in Figure 1. In addition, group III-V transistor 410 having back side 415, and front side 413 including drain electrode 414, gate electrode 416 in contact with the upper termini of through-substrate vias 408a and 408b, source pad 419 in contact with the upper terminus of through-substrate via 418 corresponds to group III-V transistor 210, in Figures 2A and 2B. Consequently, the front side terminus of through-substrate via 418 depicted as "seen through" source pad 419 and the front side termini of through-substrate vias 408a and 408b depicted as "seen through" gate electrode 416 would in fact not be visible from the perspective of Figure 4.

Group IV diode 420 having cathode 424 on top side 423, and an anode (not visible from the perspective of Figure 4) on bottom side 425 (anode not visible from the perspective of Figure 4), corresponds to group IV diode 320, in Figures 3A and 3B. It is noted that although not visible from the perspective of Figure 4, group IV diode 420 includes through-substrate vias corresponding to through-substrate vias 308a and 308b having respective top side and bottom side termini on top side 423 and bottom side 425, respectively, of active die 421, as well as an anode corresponding to anode 322 on bottom side 425. It is further noted that although similarly not visible in Figure 4, group III-V transistor 410 includes a source electrode on back side 415 of active die 411 that is electrically coupled to source pad 419 on front side 413 of active die 411 by through-substrate via 418. Moreover, insofar as group III-V transistor 410 corresponds to group III-V transistor 210 and group IV diode 420 corresponds to group IV diode 320, active die 421 of group IV diode 420 has a lateral area greater than a lateral area of active die 411 of group III-V transistor 410, as depicted in Figure 4.

Stacked composite device 401 includes a composite anode (not visible from the perspective of Figure 4) and composite cathode 404, corresponding respectively to composite anode 102 and composite cathode 104 of composite device 101, in Figure 1. As shown in Figure 4, stacked composite device 401 includes group IV diode 420 and group III-V transistor 410 stacked over group IV diode 420. According to the implementation shown in Figure 4, cathode 424 of group IV diode 420 is electrically coupled to source pad 419 through a source electrode on back side 415 of group III-V transistor 410 (corresponding to source electrode 212, in Figure 2B) and through-substrate via 418. In addition, an anode on bottom side 425 of group IV diode 420 (corresponding to anode 322, in Figure 3B) is coupled to gate electrode 416 on front side 413 of group III-V transistor 410 (e.g., by through-substrate vias 408a and 408b, and respective through-substrate vias 308a and 308b in Figures 3A and 3B) to provide a composite anode (provided by anode 322, in Figure 3B) on bottom side 405 of stacked composite device 401. Moreover, drain electrode 414 of group III-V transistor 410 provides composite cathode 404 on top side 403 of stacked composite device 401 opposite bottom side 405.

In Figure 4, stacked composite device 401 may be formed by stacking back side 415 of group III-V transistor 410 directly on top of cathode 424 of group IV diode 420, for example. In that implementation, active die 411 can be aligned such that the source electrode of group III-V transistor 410 corresponding to source electrode 212 makes direct contact with cathode 424 of group IV diode 420, and such that gate electrode 416 of group III-V transistor 410 is coupled to the anode of group IV diode 420 corresponding to anode 322 by through-substrate vias 408a and 408b, and through substrate vias corresponding to through-substrate vias 308a and 308b formed in active die 411. Moreover, the composite anode on bottom side 405 of stacked composite device 401 and corresponding to anode 322, in Figure 3B, can be coupled directly to the paddle of composite device package 400 (paddle not shown in Figure 4).

Stacking of group III-V transistor 410 on top of group IV diode 420 may be achieved using, for example, solder, conductive adhesive, conductive tape, sintering, or other attachment methods, resulting in formation of a direct mechanical contact between group IV diode 420 and group III-V transistor 410. Such direct attachment of group IV diode 420 to group III-V transistor 410 can advantageously reduce parasitic inductance and resistance, improve thermal dissipation, and reduce form factor and manufacturing cost compared to conventional packaging solutions. To improve thermal dissipation even further, active die 411 of group III-V transistor 410 and/or active die 421 of group IV diode 420 may be thinned so as to have a die thickness in a range from approximately thirty microns (30 µm) to approximately sixty microns (60 µm) to enhance thermal conductivity.

With respect to the exemplary stacked composite device implementation shown in Figure 4, the present inventors emphasize that the features and characteristics represented by that specific example are depicted in detail merely as a conceptual aid, and are not to be interpreted as limitations. It is noted that implementational details such as dimensions, and device layouts, for example, may be highly dependent upon the particular devices being utilized and the particular purpose for which the stacked composite device is designed. Consequently, the inventive principles illuminated by the specific example shown by Figure 4 are capable of considerable implementational variation without departing from the scope of the inventive concepts disclosed herein.

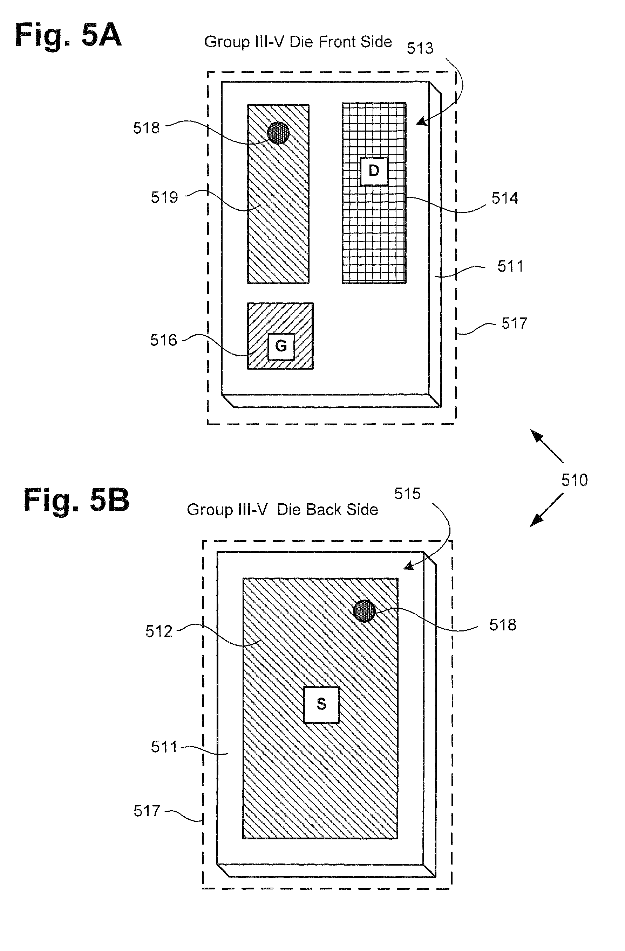

Continuing to Figures 5A and 5B, Figure 5A presents a perspective view showing front side 513 of exemplary group III-V transistor 510 suitable for use in a stacked composite device, according to another implementation, while Figure 5B presents a perspective view showing back side 515 of group III-V transistor 510. As shown by Figure 5A, group III-V transistor 510 includes active die 511 having lateral area 517, and having drain electrode 514, gate electrode 516, and source pad 519 formed on front side 513 of active die 511. As further shown by Figure 5B, source electrode 512 of group III-V transistor 510 is formed on back side 515 of active die 511. Also shown in Figures 5A and 5B are respective front and back side termini of through-substrate via 518 electrically coupling source pad 519 on front side 513 to source electrode 512 on back side 515 of active die 511. Group III-V transistor 510 having source electrode 512, source pad 519, drain electrode 514, and gate electrode 516 corresponds to group III-V transistor 110 having source 112, drain 114, and gate 116, in Figure 1, and may share any of the characteristics previously attributed to that corresponding device above.

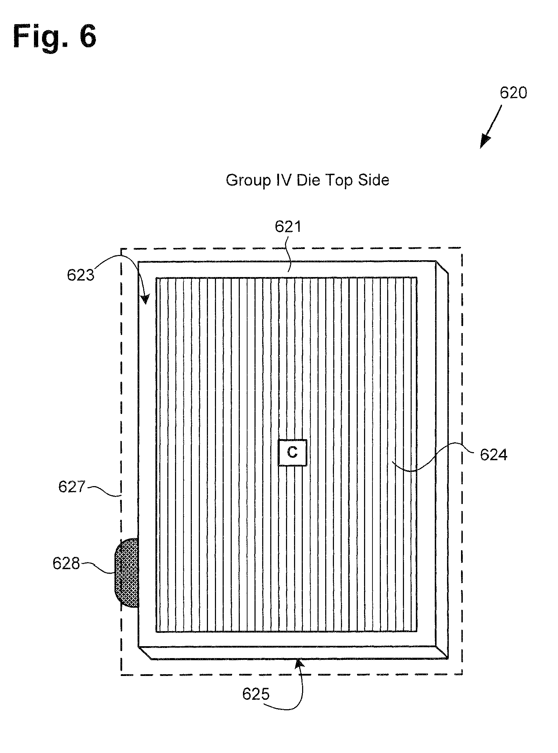

Moving to Figure 6, Figure 6 presents a perspective view showing top side 623 of exemplary group IV diode 620 suitable for use in a stacked composite device, according to one implementation. As shown by Figure 6, group IV diode 620 includes active die 621 having lateral area 627 and cathode 624 formed on top side 623 of active die 621. Group IV diode 620 may be implemented as an LV diode, such as an LV silicon diode, for example. Also shown in Figure 6 is conductive tab 628 coupled to an anode on bottom side 625 of group IV diode 620 opposite top side 623 (anode not visible from the perspective of Figure 6). It is noted that group IV diode 620 is implemented as a vertical diode according to the present example. It is further noted that lateral area 627 of active die 621 is greater than lateral area 617 of active die 611, in Figures 6A and 6B.

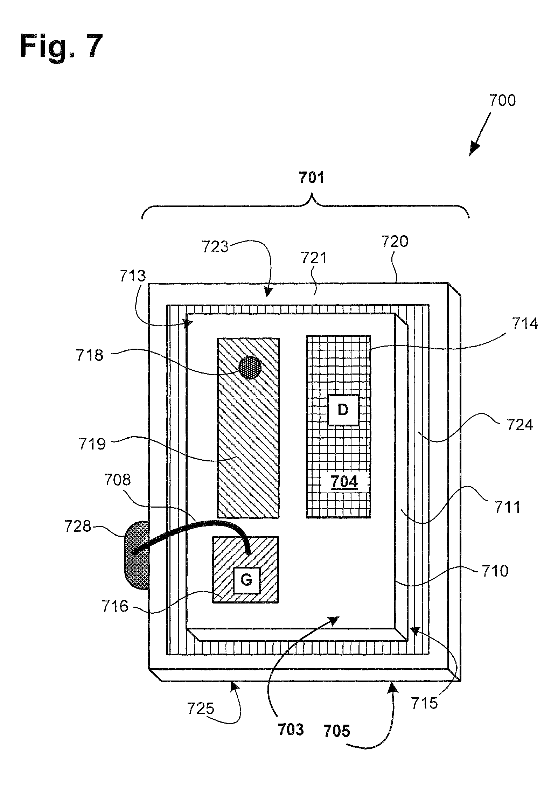

Referring now to Figure 7, Figure 7 presents a perspective view showing a top side of a packaging solution including an exemplary stacked composite device, according to one implementation. As shown in Figure 7, composite device package 700 includes stacked composite device 701 formed from group III-V transistor 710 stacked over group IV diode 720. Stacked composite device 701 corresponds to composite device 101, in Figure 1. In addition, group III-V transistor 710 having back side 715, and front side 713 including drain electrode 714, gate electrode 716, and source pad 719 in contact with the upper terminus of through-substrate via 718 corresponds to group III-V transistor 510, in Figures 5A and 5B. Consequently, the front side terminus of through-substrate via 718 depicted as "seen through" source pad 719 would in fact not be visible from the perspective of Figure 7 due to its being overlaid by source pad 719.

Group IV diode 720 having cathode 724 on top side 723, and an anode on bottom side 725 of group IV diode 720 (anode not visible from the perspective of Figure 7), corresponds to group IV diode 620, in Figure 6. It is noted that, unlike the implementation shown in Figure 4, in the implementation of Figure 7, gate electrode 716 is electrically coupled to the anode on bottom side 725 of group IV diode 720 by one or more bond wires 708 and conductive tab 728. It is further noted that insofar as group III-V transistor 710 corresponds to group III-V transistor 510 and group IV diode 720 corresponds to group IV diode 620, active die 721 of group IV diode 720 has a lateral area greater than a lateral area of active die 711 of group III-V transistor 710, as depicted in Figure 7.

Stacked composite device 701 includes a composite anode (not visible from the perspective of Figure 7) and composite cathode 704, corresponding respectively to composite anode 102 and composite cathode 104 of composite device 101, in Figure 1. As shown in Figure 7, stacked composite device 701 includes group IV diode 720 and group III-V transistor 710 stacked over group IV diode 720. According to the implementation shown in Figure 7, cathode 724 of group IV diode 720 is electrically coupled to source pad 719 through a source electrode on back side 715 of group III-V transistor 710 (corresponding to source electrode 512, in Figure 5B) and through-substrate via 718. In addition, an anode on bottom side 725 of group IV diode 720 (corresponding in general to anode 322, in Figure 3B, absent the bottom side termini of through-substrate vias 308a and 308b) is coupled to gate electrode 716 on front side 713 of group III-V transistor 710 to provide a composite anode on bottom side 705 of composite device package 700. Moreover, drain electrode 714 of group III-V transistor 710 provides composite cathode 704 on top side 703 of composite device package 700 opposite bottom side 705.

In Figure 7, stacked composite device 701 may be formed by stacking back side 715 of group III-V transistor 710 directly on top of cathode 724 of group IV diode 720, for example. In that implementation, active die 711 can be aligned such that the source electrode of group III-V transistor 710 corresponding to source electrode 512 makes direct contact with cathode 724 of group IV diode 720. Furthermore, in this implementation, gate electrode 716 of group III-V transistor 710 is coupled to the anode of group IV diode 720 at bottom side 705 of composite device package 700 through one or more bond wires 708 and conductive tab 728.

Stacking of group III-V transistor 710 on top of group IV diode 720 may be achieved using, for example, solder, conductive adhesive, conductive tape, sintering, or other attachment methods, resulting in formation of a direct mechanical contact between group IV diode 720 and group III-V transistor 710, as explained above by reference to the implementation shown by Figure 4. Such direct attachment of group IV diode 720 to group III-V transistor 710 can advantageously reduce parasitic inductance and resistance, improve thermal dissipation, and reduce form factor and manufacturing cost compared to conventional packaging solutions. To improve thermal dissipation even further, active die 711 of group III-V transistor 710 and/or active die 721 of group IV diode 720 may be thinned so as to have a die thickness in a range from approximately 30 µm to approximately 60 µm to enhance thermal conductivity. Moreover, although in the present implementation, gate electrode 716 is shown to be coupled to the anode on bottom side 725 of group IV diode 720 through one or more bond wires 708, such as gold (Au) or copper (Cu) bond wires, for example, in other implementations one or more bond wires 708 may be replaced by conductive ribbons, conductive metal clips, or other connectors comprising conductive materials such as Al, Au, Cu, and/or other metals or composite materials. It is reiterated that the features and characteristics represented by the specific example shown in Figure 7 are depicted in detail merely as a conceptual aid, and are not to be interpreted as limitations.

Thus, by stacking a group III-V transistor over a group IV diode having a larger lateral area to form a stacked composite device, the implementations disclosed in the present application provide packaging solutions with a reduced form factor, as well as reduced cost. In addition, stacking of the group III-V transistor over the group IV lateral transistor can advantageously reduce parasitic inductance and resistance, and enhance thermal dissipation so as to enable improved performance by the stacked composite device.

From the above description it is manifest that various techniques can be used for implementing the concepts described in the present application without departing from the scope of those concepts. Moreover, while the concepts have been described with specific reference to certain implementations, a person of ordinary skill in the art would recognize that changes can be made in form and detail without departing from the spirit and the scope of those concepts. As such, the described implementations are to be considered in all respects as illustrative and not restrictive. It should also be understood that the present application is not limited to the particular implementations described herein, but many rearrangements, modifications, and substitutions are possible without departing from the scope of the present disclosure.

## Claims

1. A stacked composite device having a composite anode and a composite cathode, said stacked composite device comprising:
a group IV diode;
a group III-V transistor stacked over said group IV diode;
a cathode of said group IV diode being in contact with a source of said group III-V transistor;
an anode of said group IV diode being coupled to a gate of said group III-V transistor to provide said composite anode on a bottom side of said stacked composite device;
a drain of said group III-V transistor providing said composite cathode on a top side of said stacked composite device opposite said bottom side.

2. The stacked composite device of claim 1, wherein said anode of said group IV diode is coupled to said gate of said group III-V transistor through at least one through-silicon via (TSV).

3. The stacked composite device of claim 1, wherein said anode of said group IV diode is coupled to said gate of said group III-V transistor through at least one bond wire.

4. The stacked composite device of claim 1, wherein said group III-V transistor is a normally ON device and said stacked composite device is a normally OFF device.

5. The stacked composite device of claim 1, wherein said group III-V transistor is a high-voltage transistor and said group IV diode is a low-voltage diode.

6. A composite device package comprising:
a group IV diode in a first active die;
a group III-V transistor stacked over said group IV diode in a second active die, a lateral area of said first active die being greater than a lateral area of said second active die;
a cathode of said group IV diode being in contact with a source of said group III-V transistor;
an anode of said group IV diode being coupled to a gate of said group III-V transistor to provide a composite anode on a bottom side of said composite device package;
a drain of said group III-V transistor providing a composite cathode on a top side of said composite device package opposite said bottom side.

7. The composite device package of claim 6, wherein said anode of said group IV diode is coupled to said gate of said group III-V transistor through at least one through-silicon via (TSV).

8. The composite device package of claim 6, wherein said anode of said group IV diode is coupled to said gate of said group III-V transistor through at least one bond wire.

9. The composite device package of claim 6, wherein said group III-V transistor is a normally ON device and a composite device formed of said group III-V transistor and said group IV diode is a normally OFF device.

10. The composite device package of claim 6, wherein said group III-V transistor is a high-voltage transistor and said group IV diode is a low-voltage diode.

11. A stacked composite device having a composite anode and a composite cathode, said stacked composite device comprising:
a silicon diode;
a III-Nitride transistor stacked over said silicon diode;
a cathode of said silicon diode being in contact with a source of said III-Nitride transistor;
an anode of said silicon diode being coupled to a gate of said III-Nitride transistor to provide said composite anode on a bottom side of said stacked composite device;
a drain of said III-Nitride transistor providing said composite cathode on a top side of said stacked composite device opposite said bottom side.

12. The stacked composite device of claim 11, wherein said anode of said silicon diode is coupled to said gate of said III-Nitride transistor through at least one through-silicon via (TSV).

13. The stacked composite device of claim 11, wherein said anode of said silicon diode is coupled to said gate of said III-Nitride transistor through at least one bond wire.

14. The stacked composite device of claim 11, wherein said III-Nitride transistor is a normally ON device and said stacked composite device is a normally OFF device.

15. The stacked composite device of claim 11, wherein said III-Nitride transistor is a high-voltage transistor and said silicon diode is a low-voltage diode.
